# EUROPEAN PATENT APPLICATION

(11) **EP 4 832 744 A1**
(43) Date of publication of application: **28.10.2026**
(21) Application number: 26164192.2
(22) Date of filing: 12.03.2026
(51) Int. Cl.: H10W 90/10, H10W 70/60, H10W 90/20, H10W 90/22

(54) **STACKED POWER MODULES AND METHOD OF MANUFACTURING**

(30) Priority: 13.03.2025 US 202563771248 P; 13.03.2025 US 202563771259 P
(71) Applicant: General Electric Company, Evendale, OH 45215 (US)
(72) Inventor: GOWDA, Arun Virupaksha, Niskayuna, 12309-1027 (US); HAQUE, Md Ehsanul, Niskayuna, 12309-1027 (US); BENIWAL, Neha, Niskayuna, 12309-1027 (US)
(74) Representative: Openshaw & Co.

(57) **Abstract**

An electronic component (200) includes a first assembly (202) and a second assembly (230). The first assembly (202) includes a first power overlay (POL) (204) that provides electrical connections to at least one semiconductor device (212) included in the first subassembly (202). The second subassembly (230) includes a second POL (232) that provides electrical connections to at least one semiconductor device (240) included in the second subassembly (240). The second subassembly (230) is stacked on the first subassembly (202) with electrical connections between the first and second subassemblies (202)(230) that form a power module.

## Description

### CROSS-REFERENCE TO RELATED APPLICATIONS

This application claims the benefit of U.S Provisional Patent App. No. 63/771,248, filed March 13, 2025, and U.S. Provisional Patent App. No. 63/771,259, filed March 13, 2025, which are both hereby incorporated by reference herein.

### TECHNICAL FIELD

These teachings relate generally to power modules and more particularly to stacked half-bridge power modules and methods of manufacturing such stacked half-bridge power modules.

### BACKGROUND

A power module or power electronic module is an assembly including several power components that are internally interconnected to perform a power conversion function. The power components in power modules are typically power semiconductor devices. Within power modules, these semiconductor devices must be internally connected to perform a power conversion.

### BRIEF DESCRIPTION OF DRAWINGS

Various needs are at least partially met through provision of the stacked power modules and method of manufacturing described in the following detailed description, particularly when studied in conjunction with the drawings. A full and enabling disclosure of the aspects of the present description, including the best mode thereof, directed to one of ordinary skill in the art, is set forth in the specification, which refers to the appended figures, in which:
FIG. 1 is a schematic of a half-bridge circuit;
FIG. 2 is a top view of a side-by-side half-bridge power module;
FIG. 3 is a schematic top view of a stacked half-bridge power module pin out arrangement in accordance with various embodiments of these teachings;
FIG. 4 is a schematic top view of an alternative stacked half-bridge power module pin out arrangement in accordance with various embodiments of these teachings;
FIGS. 5-13 are schematic cross-sectional side views of stacked half-bridge power modules having the pin out arrangement shown in either FIG. 3 or FIG. 4 in accordance with various embodiments of these teachings;
FIG. 14 is a flowchart of a method of manufacturing a stacked half-bridge power module of FIGS. 3-13 in accordance with various embodiments of these teachings;
FIGS. 15-17 are schematic diagrams of converters in which stacked half-bridge power modules may be incorporated in accordance with various embodiments of these teachings; and
FIGS. 18-19 are block diagrams of inverters in which stacked half-bridge power modules may be incorporated in accordance with various embodiments of these teachings.

Elements in the figures are illustrated for simplicity and clarity and have not necessarily been drawn to scale. For example, the dimensions and/or relative positioning of some of the elements in the figures may be exaggerated relative to other elements to help to improve understanding of various embodiments of the present teachings. Also, common but well-understood elements that are useful or necessary in a commercially feasible embodiment are often not depicted in order to facilitate a less obstructed view of these various embodiments of the present teachings. Certain actions and/or steps may be described or depicted in a particular order of occurrence while those skilled in the art will understand that such specificity with respect to sequence is not actually required.

### DETAILED DESCRIPTION

Generally speaking, the various aspects of the present disclosure can be employed with a power module or power electronic module including several power components that are interconnected to perform a power conversion function, such as, for example, power semiconductor devices. More specifically, in some embodiments, these internal connections can be made using power overlays (POLs), which are formed of dielectric layers and metal interconnects electroplated onto the dielectric layers to form direct metallic connections to the power semiconductor devices. The metal interconnects may be in the form of a low profile (e.g., less than 200 micrometers thick), planar interconnect structure that provides for formation of an input/output (I/O) system to and from the power semiconductor device(s).

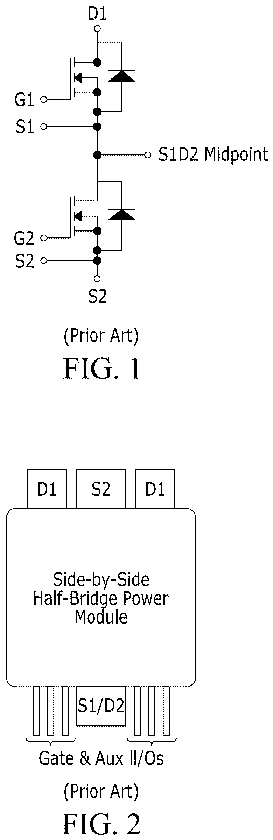

One type of power module is a half-bridge power module for use in power converters that can convert power from direct current (DC) to alternating current (AC) and vice versa. FIG. 1 illustrates a half-bridge circuit with two anti-parallel or inverse parallel switch-diode pairs, each including a respective source S1, S2, drain D1, D2, and gate G1, G2. The switches may be in the form of metal-oxide semiconductor field-effect transistors (MOSFETs) or insulated-gate bipolar transistors (IGBTs). In one implementation, drain D1 of the first switch-diode pair and source S2 of the second switch-diode pair are coupled to a DC bus. Source S1 of the first switch-diode pair is coupled to drain D2 of the second switch-diode pair to create a midpoint S1D2 or S1/D2 that may be coupled to an AC power source or load. FIG. 2 illustrates a previous half-bridge power module that may include two POL subassemblies, each including a POL and at least one power semiconductor device coupled to the POL, arranged and coupled side-by-side.

Power modules can be used in a variety of industries such as, for example, the aviation industry or automotive industry. In these industries, there is a constant drive to increase power density and efficiency of power converters. Currently, these industries are solving the power density and efficiency problem by improving the power semiconductor devices themselves and improving the packaging, such as via sintered silver die attachment and double-side cooled modules. However, these solutions leave much room for improvement in terms of area occupied by power modules. Accordingly, the electronic component and methods of manufacturing thereof as described herein form a power module with an increased power density and efficiency.

In some embodiments, the various aspects of the present disclosure provide an electronic component that forms a power module created by stacking two power overlay (POL) subassemblies on top of each other such that the source of a first or bottom POL subassembly is attached to the drain of a second or top POL subassembly. This creates a three-dimensional (3D) stacked half-bridge topology. Stacking the two POL subassemblies reduces the module footprint size and the parasitics (inductance and resistance) within the module, leading to a higher power density (kW/cm3). The stacked half-bridge power modules can also include the addition of snubber and EMI mitigation capacitors within the 3D structure. In some embodiments, a heatspreader and/or cooling channel can be included between the two stacked POL subassemblies to improve the thermal management of the module.

In some embodiments, an electronic component includes a first subassembly that includes a first power overlay (POL) that provides electrical connections to at least one semiconductor device included in the first subassembly; and a second subassembly that includes a second POL that provides electrical connections to at least one semiconductor device included in the second subassembly; wherein the second subassembly is stacked on the first subassembly with electrical connections between the first and second subassemblies that form a power module.

In some embodiments, an electronic component includes a first subassembly and a second subassembly. The first subassembly includes a first substrate structure, at least one semiconductor device disposed on the first substrate structure, and a first power overlay (POL) disposed on the at least one semiconductor device. The second subassembly includes at least one semiconductor device, a second POL disposed on the at least one semiconductor device, and a second substrate structure disposed on the second POL. The second subassembly is vertically arranged above the first subassembly with electrical connections between the first and second subassemblies that form a power module.

In some embodiments, a method of manufacturing an electronic component includes fabricating a first subassembly that includes a first power overlay (POL) that provides electrical connections to at least one semiconductor device included in the first subassembly; fabricating a second subassembly that includes a second POL that provides electrical connections to at least one semiconductor device included in the second subassembly; and coupling the second subassembly to the first subassembly by stacking the second subassembly on the first subassembly with electrical connections between the first and second subassemblies that form a power module.

The terms and expressions used herein have the ordinary technical meaning as is accorded to such terms and expressions by persons skilled in the technical field as set forth above except where different specific meanings have otherwise been set forth herein. The word "or" when used herein shall be interpreted as having a disjunctive construction rather than a conjunctive construction unless otherwise specifically indicated. The terms "coupled," "fixed," "attached to," and the like refer to both direct coupling, fixing, or attaching, as well as indirect coupling, fixing, or attaching through one or more intermediate components or features, unless otherwise specified herein. The singular forms "a", "an", and "the" include plural references unless the context clearly dictates otherwise.

Approximating language, as used herein throughout the specification and claims, is applied to modify any quantitative representation that could permissibly vary without resulting in a change in the basic function to which it is related. Accordingly, a value modified by a term or terms such as "about", "approximately", and "substantially", are not to be limited to the precise value specified. In at least some instances, the approximating language may correspond to the precision of an instrument for measuring the value, or the precision of the methods or machines for constructing or manufacturing the components and/or systems. For example, the approximating language may refer to being within a 10 percent margin.

The foregoing and other benefits may become clearer upon making a thorough review and study of the following detailed description.

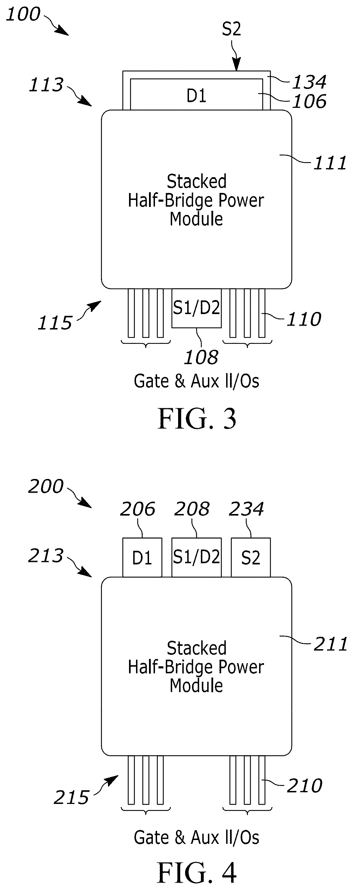

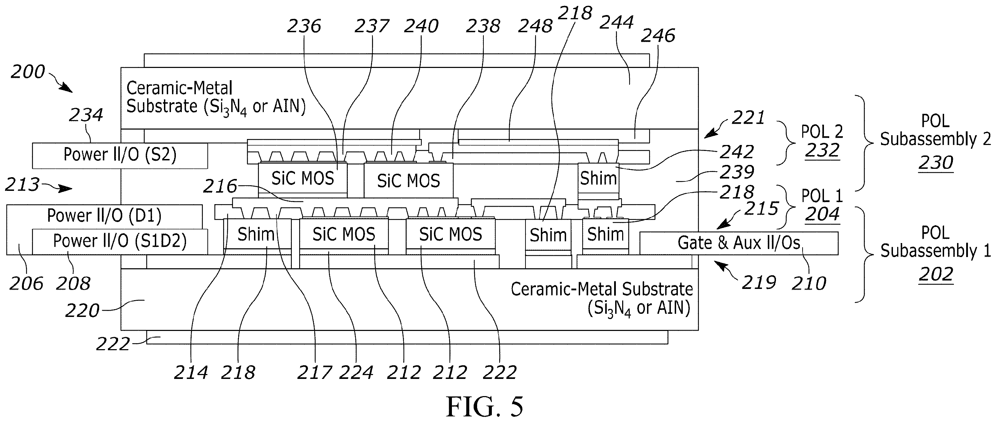

Referring now to the drawings, and in particular to FIGS. 3 and 4, schematic top views of an electronic component are shown in accordance with various embodiments of these teachings. The electronic component includes a first subassembly that includes a first power overlay (POL) providing connections to at least one semiconductor device, and a second subassembly that includes a second POL providing connections to at least one semiconductor device. The second subassembly is stacked on the first subassembly with electrical connections between the first and second subassemblies that form a power module, which in the illustrated embodiments comprises a stacked half-bridge power module. Generally, a stacked half-bridge power module refers to a power electronic module that implements a half-bridge circuit topology and includes a switching or midpoint node formed at a junction between the power semiconductors of the first and second subassemblies. The subassemblies and their internal structure are shown and described more fully below with respect to FIGS. 5-13. The electronic component includes specific lead arrangements for external connectivity. In generally, the drain (D1) lead is connected to the positive DC bus and the source (S2) lead is connected to the negative DC bus (return). The drain (D1) and source (S2) collectively process the DC power input or output, and the midpoint (S1/D2) lead is configured for AC power. The leads may be implemented as pins, tabs, or other conductive terminals, and may be formed from and/or supported by leadframes. The leadframe structures, typically formed of copper or copper alloys, serve as both mechanical support and electrical pathways, and may be mechanically and/or electrically connected to a substrate structure of a respective subassembly of the electronic component and extend externally therefrom to form the external connectors of the power module.

As shown in FIG. 3, the electronic component 100 includes a first lead 106, a second lead 134, a third lead 108, a fourth set of leads 110, and a packaging structure 111. The first lead 106 may be configured as a drain (D1) lead or pin. The second lead 134 may be configured as a source (S2) lead or pin. The third lead 108 may be configured as a midpoint (S1/D2) lead or pin. The fourth set of leads 110 may be configured as one or more gate and auxiliary input and output (I/O) leads or pins. The electronic component 100 includes a lead arrangement in which the first lead 106 overlaps with the second lead 134 on one side 113, while the third lead 108 and the fourth set of leads 110 are positioned on an opposing side 115. The overlapping of the first lead 106 and the second lead 134 results in a reduced lateral footprint compared to a side-by-side half-bridge power module and, therefore, enables higher power density. Additionally, this overlapping configuration may reduce parasitic inductance by shortening the current path between the DC terminals.

The packaging structure 111 encapsulates the internal components of the electronic component 100 ( including the first and second subassemblies) to provide mechanical protection, environmental isolation, and electrical insulation. In some embodiments, the packaging structure 111 includes an internal mold compound that surrounds the stacked subassemblies and fills the voids between and around the internal components. This mold structure may be formed using transfer molding, injection molding, or similar techniques, and may be tailored to accommodate internal features such as heatspreaders, cooling channels, or embedded capacitors.

As shown in FIG. 4, the electronic component 200 includes a first lead 206, a second lead 234, a third lead 208, a fourth set of leads 210, and a packaging structure 211. The first lead 206 may be configured as a drain (D1) lead or pin. The second lead 234 may be configured as a source (S2) lead or pin. The third lead 208 may be configured as a midpoint (S1/D2) lead or pin. The fourth set of leads 210 may be configured as one or more gate and auxiliary input and output (I/O) leads or pins. The electronic component 200 includes a lead arrangement in which the first lead 206, second lead 234, and third lead 208 are positioned on the same side 213 of the module, while the fourth set of leads 210 is located on an opposing side 215. This configuration supports compact module integration and may simplify external power and signal routing by consolidating the primary power leads on a single side.

The configurations of the electronic components 100, 200 of FIGS. 3 and 4 enable greater power density and improved electrical performance (as compared to a side-by-side half-bridge power module, e.g., as shown in FIG. 1 and 2). In the side-by-side configuration, the two POL subassemblies are arranged laterally adjacent to one another, which increases the overall footprint of the module and introduces longer internal interconnect paths between the semiconductor devices. These longer paths can result in increased parasitic inductance and resistance, which may degrade switching performance and reduce overall efficiency. In contrast, the stacked configurations of FIGS. 3 and 4 vertically align the first and second subassemblies, allowing the drain of the upper subassembly to be coupled to the source of the lower subassembly through short, low-inductance conductive elements such as copper shims. This vertical integration reduces the lateral area required for the module, enabling more compact packaging and facilitating higher power throughput within the same or smaller footprint. Additionally, the stacked architecture enables the integration of features such as internal EMI capacitors and heatspreaders.

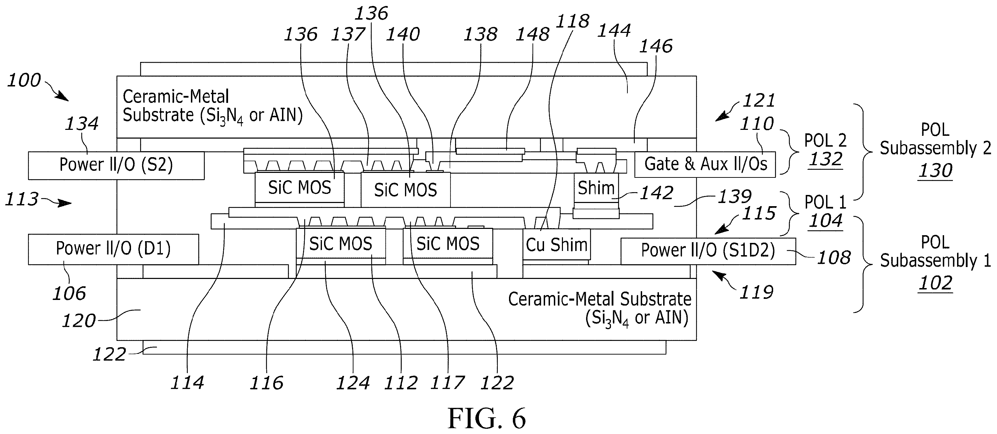

Referring now to FIGS. 5-13, schematic cross-sectional side views of the electronic component having the specific lead arrangement shown in either FIG. 3 or FIG. 4 in accordance with various embodiments of these teachings. The electronic components of FIGS. 6-10 and 13 include the lead arrangement of FIG. 3, and the electronic components of FIGS. 5, 11, and 12 include the lead arrangement of FIG. 4. Each electronic component includes a first subassembly and a second subassembly, where the second subassembly is stacked on the first subassembly with electrical connections between the first and second subassembly that form a power module, which in the illustrated embodiments comprises a stacked half-bridge power module. In general, the first subassembly includes a first power overlay (POL) that provides electrical connections to at least one semiconductor device included in the first subassembly, and the second subassembly includes a second power overlay (POL) that provides electrical connections to at least one semiconductor device in the second subassembly. The first and second subassembly each include at least one lead to provide an external connector of the power module. The first subassembly may include a drain (D1) lead, a source (S1) lead, and one or more gate and auxiliary input/output (I/O) leads, while the second subassembly may include a drain (D2) lead, a source (S2) lead, and one or more gate and auxiliary (I/O) leads. In some embodiments, the internal routing of the gate and auxiliary connections may be configured such that the gate and auxiliary (I/O) leads are provided only on one of the subassemblies, either the first or the second, depending on the desired layout and electronic requirements.

Generally, the first and second subassemblies each include at least one semiconductor device. In the illustrated embodiments, the semiconductor devices include silicon carbide (SiC) metal-oxide-semiconductor field-effect transistor (MOSFET) dies though any suitable power transistor technology (Si IGBTs, GaN HEMTs, etc.) can be used. The first and second power overlay (POL) of each subassembly provides connections to the at least one semiconductor device included in the respective subassembly. In some embodiments, two semiconductor devices included in each of the first and second subassemblies comprise an anti-parallel switch-diode pair. The first and second POLs may each include one or more dielectric layers having conductive vias and patterned metal interconnects formed thereon. These interconnects, typically formed of copper or copper alloys, are configured to route electrical signals and power between the semiconductor device terminals and external leads. In some embodiments, the POLs are implemented as overmolded structures that integrate the dielectric and interconnect layers into a compact, planar interconnection system. This configuration enables low-profile, high-density routing of gate, source, and drain terminals, while also supporting efficient thermal and electrical performance within the stacked architecture. In some embodiments, the first and second subassemblies include substrate structures to which the semiconductor device is coupled or attached. The substrate structures may include ceramic-metal substrates made of silicon nitride (Si₃N₄) or aluminum nitride (AIN), along with copper layers on either side to form a direct bonded copper substrate (DBCs). However, in various embodiments, at least one of the first and second subassemblies may omit a ceramic-metal substrate and, therefore, may have at least one non-insulated side, which is formed of a leadframe. Generally, the leadframes forming the non-insulated sides of the stacked half-bridge power modules are made of copper, but may be formed of other metals or metal alloys in various embodiments.

As described more fully below, the second subassembly is stacked on the first subassembly with electrical connections between the first and second subassemblies to form the power module. In the illustrated embodiments, these connections enable the formation of a functional half-bridge circuit by electrically coupling the drain of the second subassembly to the source of the first subassembly, thereby forming the internal midpoint node of the half-bridge. The electrical connection/interface may be formed with conductive shims, plated vias, or other low-resistance interconnect elements that provide both electrical continuity and thermal conduction across the stacked interface.

Attachment of different components may be performed using sintering (with silver, as a non-limiting example) or soldering (with tin/lead, tin/silver/copper, as non-limiting examples) based on the desired characteristics of the bonds.

The specific components and materials indicated above and in FIGS. 5-13 are non-limiting and vary between embodiments. The differences between the electrical components of FIGS. 5-13 lie in the particular arrangements of these components, additional components, or removal of components, as shown in FIGS. 5-13 and described below. The variability of the design for electrical components, e.g., stacked half-bridge power modules, shows how the design of the stacked half-bridge power modules can be tailored for different applications.

Referring to FIG. 5, the electrical component 200 is shown in accordance with some embodiments. The electrical component 200 includes a first POL subassembly 202 with a first POL 204 and a second POL subassembly 230 with a second POL 232. The first POL subassembly 202 and the second POL subassembly 230 are stacked, e.g., vertically, to form a compact, high-density half-bridge configuration. The first POL subassembly 202 includes a drain (D1) pin 206 and a midpoint (S1/D2) pin 208, both extending from a first side 213 of the module 200. Additionally, gate and auxiliary input/output (I/O) pins 210 are positioned on an opposing side 215 of the module 200, providing electrical access for control and monitoring signals. The second POL subassembly 230 includes a source (S2) pin 234 coming out from the first side 213. In other words, in the stacked arrangement, the drain (D1) pin 206, the midpoint (S1/D2) pin 208 and the source (S2) pin 234 are on the same side 213, with the gate and auxiliary I/O pins 210 on the opposing side 215.

The first POL 204 includes one or more power semiconductor devices or dies 212, such as silicon carbide (SiC) MOSFETs. The power semiconductor devices or dies 212 are mounted on first substrate structure 219 that includes a ceramic-metal substrate 220, which may be formed from thermally conductive and electrically insulating materials such as silicon nitride (Si₃N₄) or aluminum nitride (AIN). The substrate 220 can include copper layers 222 on both its top and/or bottom surfaces, forming a direct bonded copper (DBC) substrate to facilitate efficient thermal dissipation and electrical conduction.

The first POL 204 includes a dielectric layer 214 having vias 217 and patterned metal interconnects 216 formed thereon to provide the respective connections (e.g., low-profile, planar electrical routing) to the power semiconductor devices 212 and the external terminals of the module. The vias 217 are conductive openings formed through the dielectric layer 214 that electrically connect different levels of the interconnect structure, enabling vertical signal and power routing between terminals of the power semiconductor devices 212 and the drain/source pins or leadframes. The vias 217 may be filled or plated with conductive materials such as copper to ensure low-resistance electrical continuity. The metal interconnects 216 may be formed from copper and patterned to define the desired routing paths across the POL surface. Copper shims 218 are positioned within the POL 204 to enhance both electrical conduction and thermal dissipation. In some embodiments, the copper shims 218 form part of the conduction/current carrying paths and electrically complete one or more circuit connections between the power semiconductor devices 212, the interconnects 216, and/or the stacked second POL 234. The power semiconductor devices 212 are mounted to a first substrate structure 219, which comprises a ceramic-metal substrate 220 such as, silicon nitride (Si₃N₄) or aluminum nitride (AIN), with the copper layers 222 bonded thereto to form a direct bonded copper (DBC) substrate. In some embodiments, the devices 212 are bonded (e.g., mechanically and electrically) to the substrate 220 using a high-performance attachment layer 224, which may include sintered silver, conductive adhesives, or solder materials such as tin-lead, pure tin, tin-silver, or tin-copper alloys.

The second POL 232, includes one or more power semiconductor devices or dies 236, such as silicon carbide (SiC) MOSFETs. A second substrate structure 221 is formed or positioned over the second POL 232. The second substrate structure 221 includes a ceramic-metal substrate 244, which may be formed from thermally conductive and electrically insulating materials such as silicon nitride (Si₃N₄) or aluminum nitride (AIN). The substrate 244 can include copper layers 246 on both its top and/or bottom surfaces, forming a direct bonded copper (DBC) substrate to facilitate efficient thermal dissipation and electrical conduction.

The second POL 232 includes one or more dielectric layers 238 having vias 237 and patterned metal interconnects 240 formed thereon to provide the respective connections (e.g., low-profile, planar electrical routing ) to the power semiconductor device 236 and the external terminals of the module. The vias 237 are conductive openings formed through the dielectric layer 238 that electrically connect different levels of the interconnect structure, enabling vertical signal and power routing between terminals of the power semiconductor device 236 and the drain/source pins or leadframes. The vias 237 may be filled or plated with conductive materials such as copper to ensure low-resistance electrical continuity. The metal interconnects 240 may be formed from copper and patterned to define the desired routing paths across the POL surface. Copper shims 242 are positioned within the POL 232 to enhance both electrical conduction and thermal dissipation. In some embodiments, the copper shims 242 form part of the conduction/current carrying paths and electrically complete one or more circuit connections between the power semiconductor devices 236, the interconnects 240, and/or the stacked first POL 204. The second POL 232 can be bonded to the second substrate structure 221 using a sintered silver layer 248, conductive adhesive, or soldered layer, in the same or similar manner as the bonding described above with respect to the first POL 204. Additionally or alternatively, in some embodiments, the power semiconductor device 236 can be bonded to the first POL 204 in a similar manner. For example, the drain of the power semiconductor device 236 can be attached to the interconnect 216 via sintering, soldering, etc.

As stated above, the second subassembly 230 is stacked on the first subassembly 202. To form the power module 200, electrical connections are made between the first and second subassemblies 202, 230. The electrical connections can be formed through one or more conductive interfaces including electric coupling of the power semiconductor devices to their respective POLs, patterned metal interconnects and vias within the POL's, and conductive shims. For example, where the power semiconductor devices comprise vertical devices such as MOSFETs, a drain terminal of each device can be electrically coupled directly to the respective POL through the patterned interconnects and associated attachment layers. Similarly, copper shims 218, 242 are positioned between selected regions of the first and second POLs 204, 232 to electrically and thermally couple corresponding interconnect layers 216, 240. Collectively, these conductive paths electrically couple, for example, the drain (D2) of the second subassembly 230 to the source (S1) of the first subassembly 202, thereby forming the internal half-bridge midpoint node or midpoint (S1/D2) lead 208. This stacked configuration enables a compact, high-density power module with minimized parasitic inductance, efficient current flow between the vertically arranged switching devices, improved thermal performance, and simplified system-level integration compared to conventional side-by-side half-bridge modules.

In some embodiments, the electrical component 200 includes a dielectric filler material 239 to fill gaps between components of the first and second subassemblies 202, 230. For example, the dielectric filler material 239 may be provided between and around the power semiconductor devices or dies 212, 236 and shims 218, 242 to provide additional structural integrity.

In some embodiments, the first and second POL 204, 232 may be implemented as overmolded structures. In some embodiments, overmolding is performed after the first and second subassemblies 202, 230 are stacked and electrically coupled. In other embodiments, each of the first and second subassemblies 202, 230 may be overmolded separately prior to stacking. In such configurations, after the overmolded subassemblies are stacked and electrically interconnected, additional insulating or encapsulating material may be introduced to fill gaps between the subassemblies and around the electrical interconnections.

Referring to FIG. 6, the electrical component 100 is shown in accordance with some embodiments. The electrical component 100 includes a first subassembly 102 with a first POL 104 and a second subassembly 130 with a second POL 132. The first subassembly 102 and the second subassembly 130 are stacked, e.g., vertically, to form a compact, high-density half-bridge configuration. The first subassembly 102 includes a drain (D1) pin 106 extending from a first side 113, and a midpoint (S1/D2) pin 108 extending from an opposing side 115 of the module 100. The second POL subassembly 130 includes a source (S2) pin 134 coming out from the first side 113, and gate and auxiliary input/output (I/O) pins 110 are positioned on an opposing side 115 of the module 100, providing electrical access for control and monitoring signals. In other words, in the stacked arrangement, the drain (D1) pin 106 and the source (S2) pin 134 are on the same side 113, with the midpoint (S1/D2) pin 108 and the gate and auxiliary I/O pins 110 on the opposing side 115. While the gate and auxiliary (I/O) pins 110 are included in the second subassembly 130, in other embodiments, the gate and auxiliary (I/O) pins 110 may alternatively be included in the first subassembly 102.

The first POL 104 includes one or more power semiconductor devices or dies 112, such as silicon carbide (SiC) MOSFETs. The power semiconductor devices or dies 112 are mounted on a first substrate structure 119, which includes a ceramic-metal substrate 120, which may be formed from thermally conductive and electrically insulating materials such as silicon nitride (Si₃N₄) or aluminum nitride (AIN). The substrate 120 can include copper layers 122 on both its top and/or bottom surfaces, forming a direct bonded copper (DBC) substrate to facilitate efficient thermal dissipation and electrical conduction.

The first POL 104 includes a dielectric layer 114 having vias 117 and patterned metal interconnects 116 formed thereon to provide the respective connections (e.g., low-profile, planar electrical routing) to the power semiconductor device 112 and the external terminals of the module. The vias 117 are conductive openings formed through the dielectric layer 114 that electrically connect different levels of the interconnect structure, enabling vertical signal and power routing between terminals of the power semiconductor device 112 and the drain/source pins or leadframes. The vias 117 may be filled or plated with conductive materials such as copper to ensure low-resistance electrical continuity. The metal interconnects 116 may be formed from copper and patterned to define the desired routing paths across the POL surface. Copper shims 118 are positioned within the POL 104 to enhance both electrical conduction and thermal dissipation. In some embodiments, the copper shims 118 form part of the conduction/current carrying paths and electrically complete one or more circuit connections between the power semiconductor devices 112, the interconnects 116, and/or the stacked second POL 134. The power semiconductor devices 112 are mounted to a first substrate structure 119, which comprises a ceramic-metal substrate 120 such as, silicon nitride (Si₃N₄) or aluminum nitride (AlN), with the copper layers 122 bonded thereto to form a direct bonded copper (DBC) substrate. In some embodiments, the devices 112 are bonded (e.g., mechanically and electrically) to the first substrate structure 119 using a high-performance attachment layer 124, which may include sintered silver, conductive adhesives, or solder materials such as tin-lead, pure tin, tin-silver, or tin-copper alloys.

The second POL 132 includes one or more power semiconductor devices or dies 136, such as silicon carbide (SiC) MOSFETs. A second substrate structure 121 is formed or positioned over the second POL 132. The second substrate structure 121 includes a ceramic-metal substrate 144, which may be formed from thermally conductive and electrically insulating materials such as silicon nitride (Si₃N₄) or aluminum nitride (AIN). The substrate 144 can include copper layers 146 on both its top and/or bottom surfaces, forming a direct bonded copper (DBC) substrate to facilitate efficient thermal dissipation and electrical conduction.

The second POL 132 includes a dielectric layer 138 having vias 137 and patterned metal interconnects 140 formed thereon to provide the respective connections (e.g., low-profile, planar electrical routing ) to the power semiconductor devices 136 and the external terminals of the module. The vias 137 are conductive openings formed through the dielectric layer 138 that electrically connect different levels of the interconnect structure, enabling vertical signal and power routing between terminals of the power semiconductor device 136 and the drain/source pins or leadframes. The vias 137 may be filled or plated with conductive materials such as copper to ensure low-resistance electrical continuity. The metal interconnects 140 may be formed from copper and patterned to define the desired routing paths across the POL surface. Copper shims 142 are positioned within the POL 132 to enhance both electrical conduction and thermal dissipation. In some embodiments, the copper shims 242 form part of the conduction/current carrying paths and electrically complete one or more circuit connections between the power semiconductor devices 236, the interconnects 240, and/or the stacked first POL 204. The second POL 132 can be bonded to the second substrate structure 121 using a sintered silver layer 148, conductive adhesive, or soldered layer, in the same or similar manner as the bonding described above with respect to the first POL 104. Additionally or alternatively, in some embodiments, the power semiconductor devices 136 can be bonded to the first POL 104 in a similar manner.

As stated above, the second subassembly 130 is stacked on the first subassembly 102. To form the power module 100, electrical connections are made between the first and second subassemblies 102, 130. The electrical connections can be formed through one or more conductive interfaces including electric coupling of the power semiconductor devices to their respective POLs, patterned metal interconnects and vias within the POL's, and conductive shims. For example, where the power semiconductor devices comprise vertical devices such as MOSFETs, a drain terminal of each device can be electrically coupled directly to the respective POL through the patterned interconnects and associated attachment layers. Similarly, copper shims 118, 142 are positioned between selected regions of the first and second POLs 104, 132 to electrically and thermally couple corresponding interconnect layers 116, 140. Collectively, these conductive paths electrically couple, for example, the drain (D2) of the second subassembly 130 to the source (S1) of the first subassembly 102, thereby forming the internal half-bridge midpoint node or midpoint (S1/D2) lead 108. This stacked configuration enables a compact, high-density power module with minimized parasitic inductance, efficient current flow between the vertically arranged switching devices, improved thermal performance, and simplified system-level integration compared to conventional side-by-side half-bridge modules.

In some embodiments, the electrical component 100 includes a dielectric filler material 139 to fill gaps between components of the first and second subassemblies 102, 130. For example, the dielectric filler material 139 may be provided between and around the power semiconductor devices or dies 112, 136 and shims 118, 142 to provide additional structural integrity.

In some embodiments, the first and second POL 104, 132 may be implemented as overmolded structures. In some embodiments, overmolding is performed after the first and second subassemblies 102, 130 are stacked and electrically coupled. In other embodiments, each of the first and second subassemblies 102, 130 may be overmolded separately prior to stacking. In such configurations, after the overmolded subassemblies are stacked and electrically interconnected, additional insulating or encapsulating material may be introduced to fill gaps between the subassemblies and around the electrical interconnections.

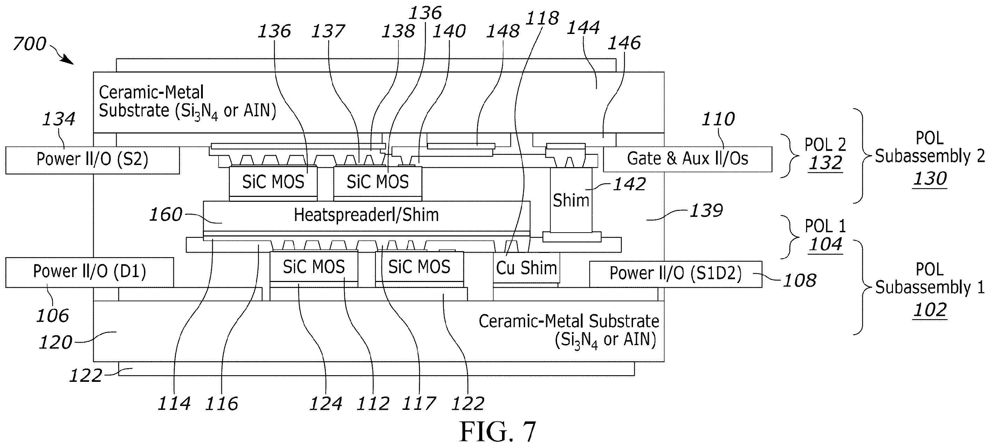

Referring to FIG. 7, an electrical component 700 is shown in accordance with some embodiments. The electrical component 700 is similar in many respects to the electrical component 100 of FIG. 6. The same part numbers refer to the same or similar components as those described in FIG. 6 and only general differences will be discussed.

As shown in FIG. 7, the electrical component 700 includes a thermally conductive heatspreader or shim 160 positioned between the first and second subassemblies 102, 130. The heatspreader or shim 160 (which forms an intermediate layer) may enhance thermal management by facilitating heat dissipation away from the power semiconductor devices 112, 136 during operation. In some embodiments, the heatspreader or shim 160 can be formed from copper or another high thermal conductivity material and may also serve as a mechanical spacer to optimize the vertical alignment of the stacked structure. In some embodiments, the heatspreader 160 can include a heat pipe or a cooling structure with one or more cooling channels through which cooling fluid flows to improve thermal performance by enabling active heat removal from the interior of the electronic component 700.

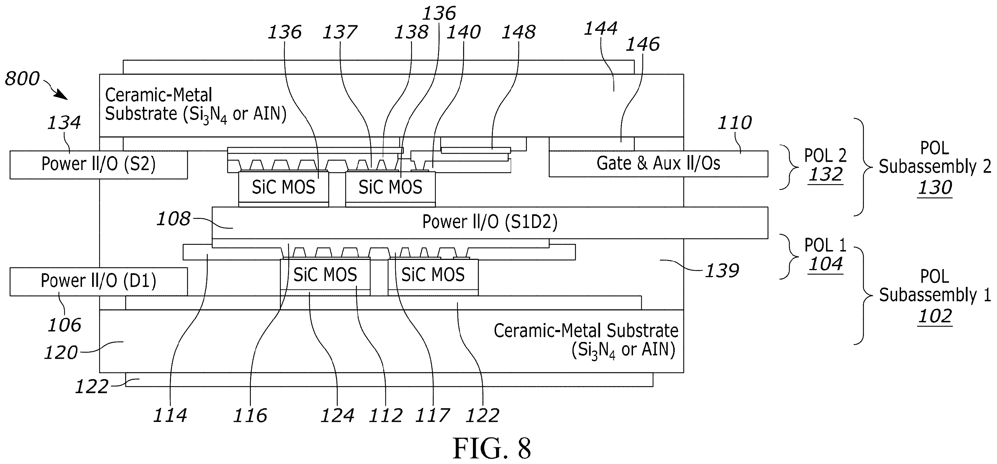

Referring to FIG. 8, an electrical component 800 is shown in accordance with some embodiments. The electrical component 800 is similar in many respects to the electrical component 100 of FIG. 6. The same part numbers refer to the same or similar components as those described in FIG. 6 and only general differences will be discussed.

As shown in FIG. 8, the midpoint (S1/D2) pin 108 is positioned between the first subassembly 102 and the second subassembly 130 (rather than on a substrate of the first or second subassemblies). More specifically, in some embodiments, the midpoint (S1/D2) pin 108 is electrically coupled to the first POL 104 through the interconnect structure (e.g., patterned metal interconnects 116, and dielectric layer 114) and to the semiconductor devices 136 of the second POL 132, forming the internal half-bridge node between the source terminal of the first subassembly and the drain terminal of the second subassembly. By fabricating the midpoint (S1/D2) pin 108 at the interface between the two subassemblies, this embodiment enables direct electrical coupling without the utilization of intermediate copper shims. The elimination of copper shims simplifies the assembly process, reduces thermal and mechanical complexity, and may improve manufacturability and reliability. Additionally, this arrangement provides an alternative signal and power mapping strategy within the electronic component 800, while maintaining a compact form factor and low-inductance current path.

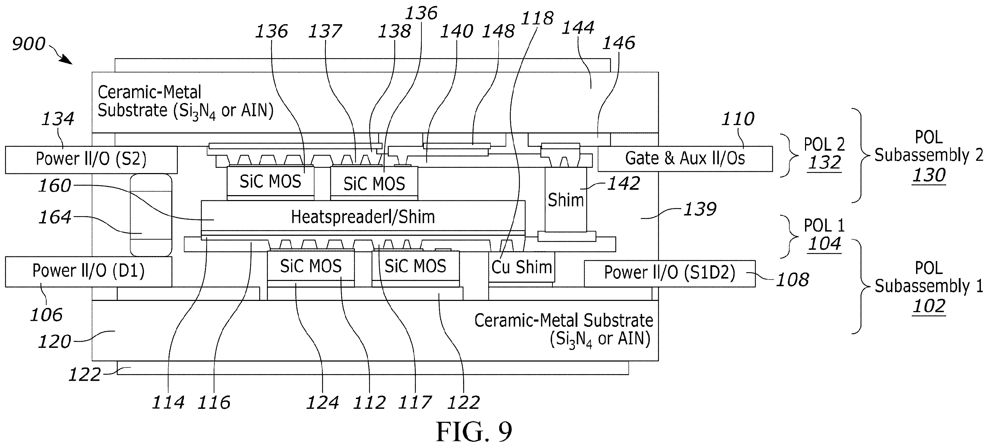

Referring to FIG. 9, an electrical component 900 is shown in accordance with some embodiments. The electrical component 900 is similar in many respects to the electrical component 700 of FIG. 7. The same part numbers refer to the same or similar components as those described in FIG. 6 and only general differences will be discussed.

As shown in FIG. 9, the electrical component 900 includes the heatspreader or shim 160 between the first and second subassemblies 102, 130. In addition, an electromagnetic interference (EMI) capacitor 164 is between (e.g., electrically coupled) the drain (D1) pin 106 and the source (S2) pin 134. The EMI capacitor 164 provides EMI mitigation within the stacked half-bridge power module. The EMI capacitor 164, which may also be referred to as a high-frequency decoupling capacitor, can provide a low-inductance path for high-frequency switching transients, thereby mitigating voltage overshoot and reducing conducted EMI. The compact, vertically stacked architecture of the module (with the close coupling of the capacitor to switching nodes) allows for the integrated EMI suppression. That is, this EMI solution would not be available at this level of effectiveness without stacking POL subassemblies (e.g., as compared to the side-by-side assemblies of FIGS. 1 and 2 as shown and described above).

While not all embodiments of the stacked half-bridge power modules described herein and shown in the drawings specifically include this EMI capacitor, it is generally contemplated that the EMI capacitor may be incorporated into the embodiments of the stacked half-bridge power modules described herein.

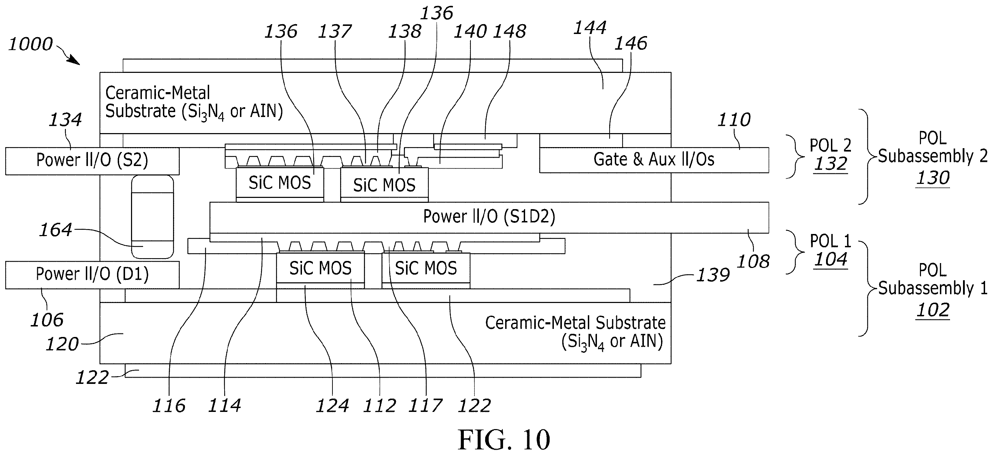

Referring to FIG. 10, an electrical component 1000 is shown in accordance with some embodiments. The electrical component 1000 is similar in many respects to the electrical component 800 of FIG. 8. The same part numbers refer to the same or similar components as those described in FIG. 6 and only general differences will be discussed.

As shown in FIG. 10, the midpoint (S1/D2) pin 108 is positioned between the first subassembly 102 and the second subassembly 130 (rather than on a substrate of the first or second subassemblies). This location of the midpoint (S1/D2) pin 108 provides another option for signal and power mapping within the electrical component 800. In addition, an electromagnetic interference (EMI) capacitor 164 is between (e.g., electrically coupled) the drain (D1) pin 106 and the source (S2) pin 134. As described above, the capacitor 164 can provide a significant advantage for EMI mitigation within the stacked half-bridge power module.

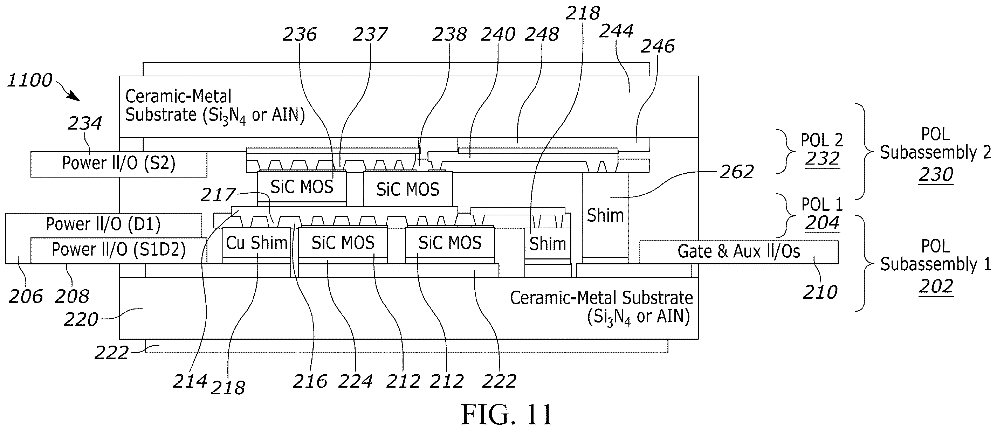

Referring now to FIG. 11, an electrical component 1100 is shown in accordance with some embodiments. The electrical component 1100 is similar in many respects to the electrical component 200 of FIG. 5. The same part numbers refer to the same or similar components as those described in FIG. 5 and only general differences will be discussed.

As compared to the electrical component 200 of FIG. 5, the electrical component 1100 includes one or more shims 262 extending directly between the substrate 220 of the first POL subassembly 202 and the second POL subassembly 230. More specifically, the shim 262 extends directly between the substrate 220 of the first POL subassembly 202 and the interconnect structure (e.g., one or more dielectric layers 238, and patterned metal interconnects 240) of the second POL subassembly 230. This arrangement bypasses the first POL subassembly 202 interconnect structure, enabling a more direct electrical and thermal path between the first and second POL subassemblies 202, 230 and simplifying routing.

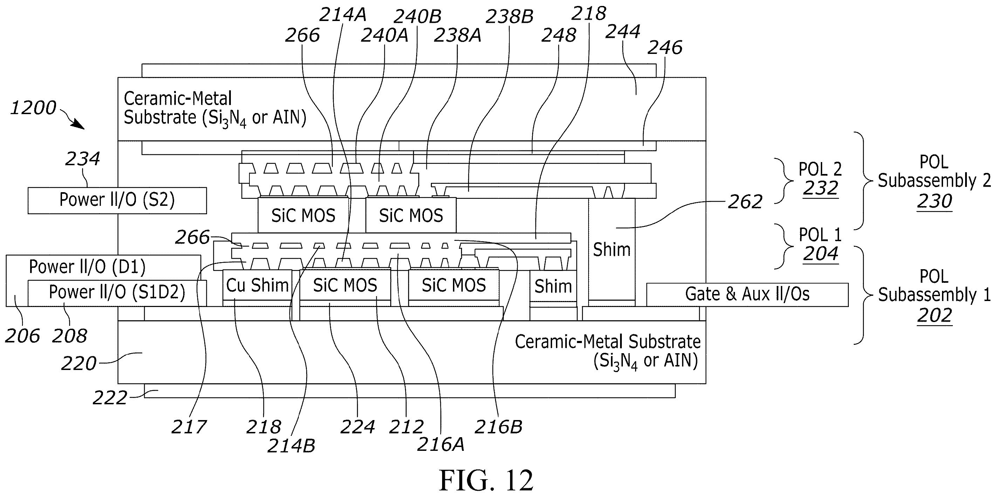

Referring now to FIG. 12, an electrical component 1200 is shown in accordance with some embodiments. The electrical component 1200 is similar in many respects to the electrical component 1100 of FIG. 11. The same part numbers refer to the same or similar components as those described in FIG. 5 and only general differences will be discussed.

As shown in FIG. 12, the first POL 204 and the second POL 232 are each implemented as double-layer (or two-layer) POLs. More specifically, the first double-layer POL 204 includes two dielectric layers 214A and 214B, which are vertically stacked. The dielectric layer 214A has a patterned metal interconnect layer 216A formed thereon, and the dielectric layer 214B has a patterned metal interconnect layer 216B formed thereon. Similarly, the second double-layer POL 232 includes two dielectric layers 238A and 238B, which are vertically stacked. The dielectric layer 238A has a patterned metal interconnect layer 240A formed thereon, and the dielectric layer 238B has a patterned metal interconnect layer 240B formed thereon. The interconnect layers may be formed from copper or copper alloys and are patterned to route power and signal paths between the semiconductor device terminals and external leads. Vertical conductive vias 266 are formed through the dielectric layers 214A, 214B, 238A, and 238B to electrically couple the stacked interconnect layers, enabling multi-level routing within a compact footprint. The additional routing layer allows for improved separation of high-current and control signal paths, reducing electromagnetic interference and parasitic coupling. It also enables more efficient use of the available surface area, allowing for denser integration and flexible arrangement of semiconductor devices and more flexible terminal placement. Furthermore, the double-layer configuration can simplify assembly by reducing the need for precise alignment of the assemblies.

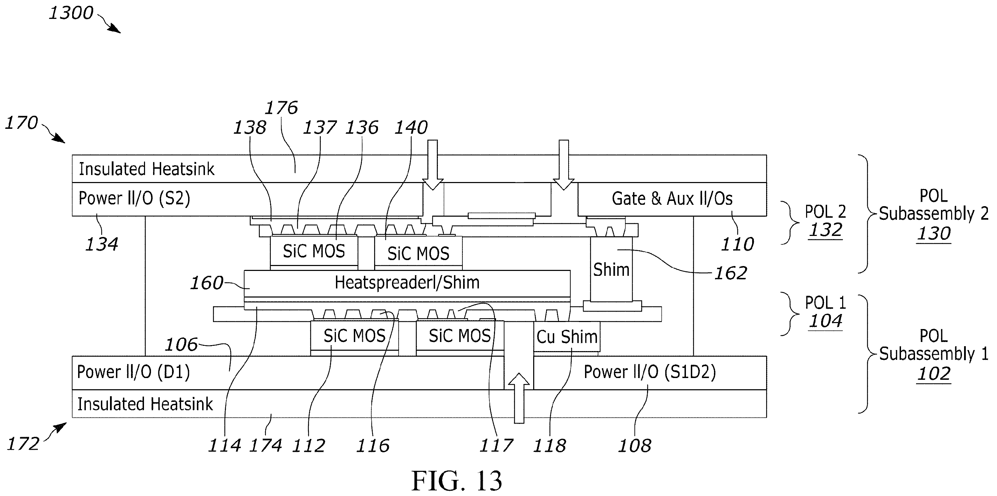

Referring now to FIG. 13, an electrical component 1300 is shown in accordance with some embodiments. The electrical component 1300 is similar in many respects to the electrical component 700 of FIG. 7. The same part numbers refer to the same or similar components as those described in FIG. 6 and only general differences will be discussed.

As shown in FIG. 13, the electrical component 1300 differs from the other embodiments in that the electronic component 1300 does not include a ceramic substrate. The electrical component 1300 is non-insulated and includes only leadframes on its top side 170 and bottom side 172. That is, the electrical component 1300 includes the drain (D1) pin 106 and midpoint (S1/D2) pin 108 on its bottom side 172 of the first subassembly 102 and the source (S2) pin 134 and gate and auxiliary input/output (I/O) pins 110 on its top side 170 of the second subassembly 130. However, in some embodiments, either the top side 170 or only the bottom side 172 of the electrical component 1300 is non-insulated. The non-insulated side(s) of the electrical component 1300 of FIG. 13 may be incorporated into any of the other embodiments of the electrical components described above.

In some embodiments, the electrical component 1300 includes an insulated ceramic heatsink 174, 176 on opposing sides 170, 172 of the first and second subassemblies 102, 130, along with cooling channels. In some embodiments, the electrical component 1300 may include a thermally conductive, electrically insulating layer between the electrical component 1300 and a metal heatsink structure. The electrical component 1300 further includes the heatspreader/shim 160 of FIGS. 7 and 9 between the first and second subassemblies 102, 130 to improve the thermal management. A thermally conductive insulating layer can also be applied to the top and bottom-side leadframes with the insulating ceramic heatsinks. If the stacked half-bridge power module includes this thermally conductive insulating layer, a metal cold plate may be used with the electrical component. Alternatively, if an electrically conductive layer is used, an insulative cold plate (for example, a ceramic cold plate) is used. In this embodiment of the power module, the cooling provided by the heatsinks and heatspreader/shim make this electronic component a double-side cooled heatsink with three cooling layers. However, the heatspreader/shim may not be included in some embodiments.

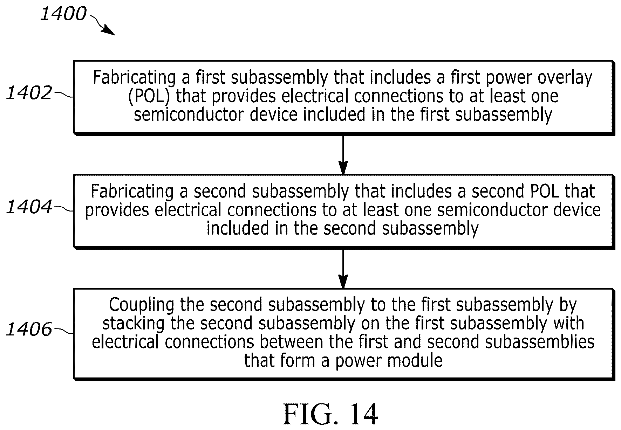

Referring to FIG. 14, a method 1400 of manufacturing an electrical component is shown in accordance with various embodiments. The method 1400 of manufacturing can be applied to manufacture the electrical component of any of the embodiments of FIGS. 3-13 described above. The method 1400 may include additional steps not shown, and the steps may be performed in any suitable order or in parallel, depending on the implementation.

At step 1402, the method 1400 includes fabricating a first subassembly that includes a first power overlay (POL) configured to provide electrical connections to at least one semiconductor device included in the first subassembly. In some embodiments, fabricating the first subassembly includes coupling the at least one semiconductor device to a first substrate structure, such as a ceramic-metal substrate (e.g., a direct bonded copper (DBC) substrate), and coupling a first leadframe to the first substrate structure to form external terminals.

At step 1404, the method 1400 includes fabricating a second subassembly that includes a second POL configured to provide electrical connections to at least one semiconductor device included in the second subassembly. In some embodiments, fabricating the second subassembly includes coupling a second substrate structure to the second POL and coupling a second leadframe to the second substrate structure.

In some embodiments, at least one of the first or second POLs may be fabricated as a two-layer POL, including multiple patterned interconnect layers separated by dielectric layers and interconnected by conductive vias.

At step 1406, the method 1400 includes coupling the second subassembly to the first subassembly by stacking the second subassembly on the first subassembly with electrical connections between the first and second subassemblies that form a power module. In some embodiments, the coupling may occur either during fabrication of the second subassembly or after its fabrication is complete. The electrical connection between the subassemblies may be facilitated by placing a conductive shim between the first and second POLs or between the second POL and the first substrate structure. Additionally, or alternatively, the electrical connection can be formed through one or more fabricated conductive interfaces including electric coupling of the power semiconductor devices to their respective POLs, patterned metal interconnects and vias within the POL's, and conductive shims. For example, where the power semiconductor devices comprise vertical devices such as MOSFETs, a drain terminal of each device can be electrically coupled directly to the respective POL through the patterned interconnects and associated attachment layers. In some embodiments, a heat spreader may be placed between the subassemblies to improve thermal management. Additionally, a third leadframe or an electromagnetic interference (EMI) mitigation capacitor may be positioned between the subassemblies to provide further electrical functionality and performance enhancements.

In some embodiments, the method 1400 further includes molding the stacked subassemblies using a transfer molding, injection molding, or similar encapsulation process to form a protective packaging structure. This molded structure may encapsulate the internal components and support the external leads, completing the formation of the electronic component. In some embodiments, the method 1400 further includes trimming and forming the external leads after molding the stacked subassemblies to remove excess leadframe material and shape the leads into their final configuration to facilitate electrical connection to external circuitry.

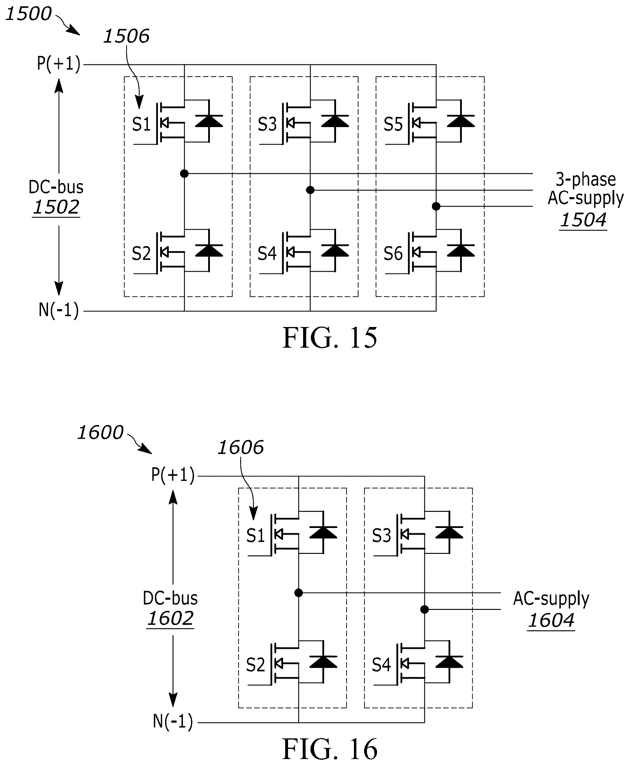

Referring now to FIGS. 15-17, examples of converters and inverters in which the electrical components of FIGS. 3-13 may be used are shown, according to various embodiments.

Referring to FIG. 15, a two-level, three-phase voltage source converter 1500 is shown according to some embodiments. The three-phase voltage source converter 1500 includes a DC bus 1502 coupled to a three-phase AC power supply or AC load 1504 via six switches S1-S6 1506. The electronic components of FIGS. 3-13 may be used as the following pairs of switches: S1-S2, S3-S4, and S5-S6. This modular integration supports compact, high-efficiency converter designs. Common applications of the three-phase voltage source converter 1500 may include variable-speed motor drives, high-voltage DC (HVDC) transmission systems, and renewable energy systems for grid integration.

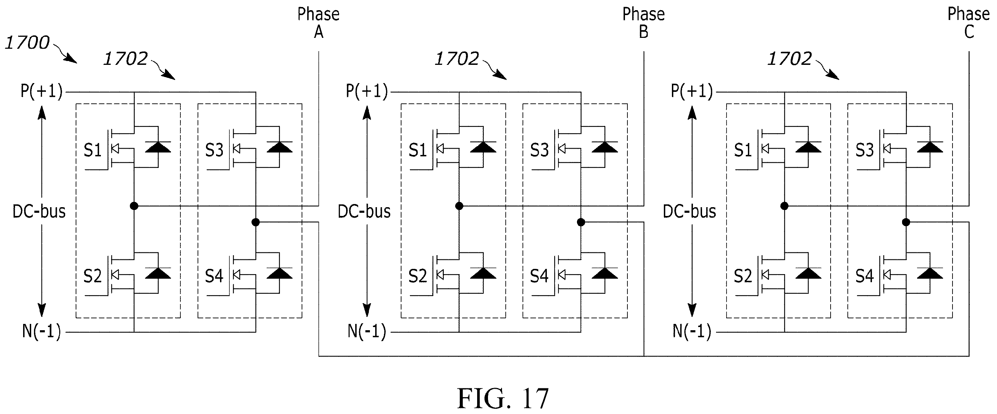

Referring now to FIGS. 16 and 17, two full-bridge converters are shown, according to various embodiments. FIG. 16 illustrates a single-phase H-bridge converter 1600, and FIG. 17 illustrates a three-phase H-bridge converter 1700. Like the converter of FIG. 15, the single-phase H-bridge converter 1600 of FIG. 16 includes a DC bus 1602 coupled to a three-phase AC power supply or AC load 1604 via switches 1606. However, the single-phase H-bridge converter 1600 includes four switches S1-S4, and the electronic component of FIGS. 3-13 may be used as the following pairs of switches: S1-S2 and S3-S4.

As shown in FIG. 17, the three-phase H-bridge converter 1700 includes three single-phase H-bridge converters 1702, one for each phase, and the electrical component of FIGS. 3-13 may be used in the same manner as with the single-phase H-bridge converter. The H-bridge converters 1702 can be further cascaded to achieve higher voltage levels using the electrical components which form the stacked-half bridge power module in a similar manner. Common applications of H-bridge converters include interfacing with a utility grid when producing renewable energy, voltage regulation, VAR compensation, and harmonic filtering.

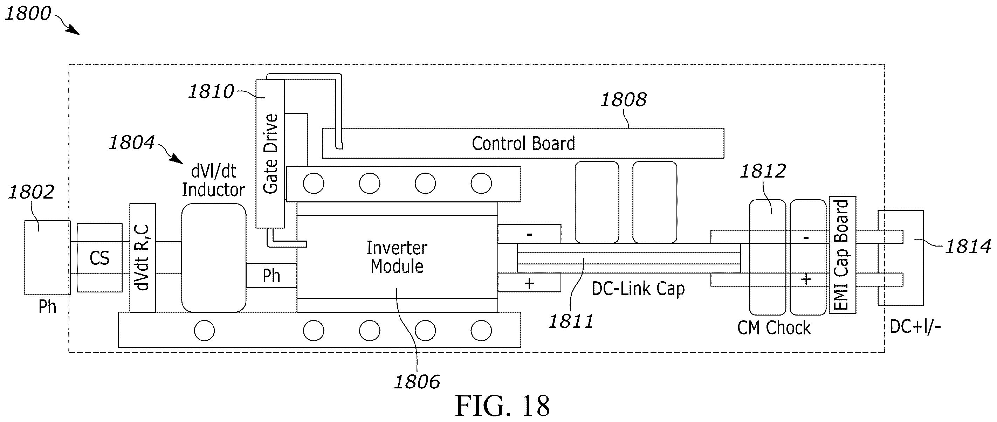

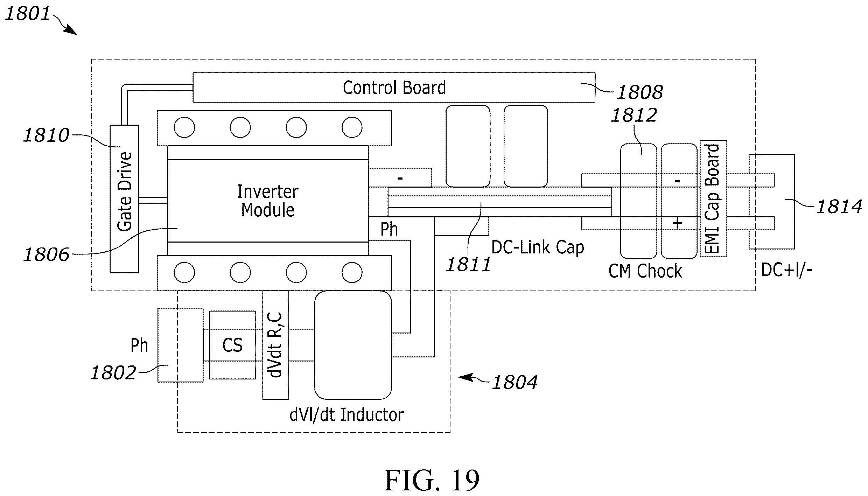

Referring now to FIGS. 18 and 19, bidirectional inverters in which the electronic components of FIGS. 6-10 and 13 with the pin out arrangement of FIG. 3 may be used and in which the electronic components of FIGS. 5, 11, and 12 with the pin out arrangement of FIG. 4 may be used, respectively, are shown, according to an embodiment. The inverters 1800, 1801 include a three-phase input (for AC-to-DC power conversions) or output (for DC-to-AC power conversions) (Ph) 1802 coupled to an LCR filter 1804 (dVdt R,C, dV/dt Inductor) including one or more capacitors, resistors, and inductors to smooth the current and voltage waveforms. The inverters 1800, 1801 of FIGS. 18 and 19 differ in the location of the LCR filter 1804. The LCR filter 1804 is coupled to an inverter module 1806 including a plurality of electronic components that from power modules, such as stacked half-bridge power modules.

The inverter module 1806 receives signals from a control board 1808 via a gate drive 1810. The inverter module 1806 may operate under a specific technique such as pulse width modulation, as a non-limiting example. During an AC-to-DC power conversion, the inverter module 1806 converts a received AC power to DC power for a DC link 1811 having DC link capacitors (DC-Link Cap) for smoothing the DC link voltage. During a DC-to-AC power conversion, the inverter module 1806 converts a DC power from the DC link 1811 to AC power for the AC load connected to the Ph (AC) terminals 1802.. The DC link 1811 is coupled to a common mode choke (CM Choke) 1812 configured to mitigate or eliminate EMI and then to a DC input (for DC-to-AC power conversions) or output (for AC-to-DC power conversions) (DC+/-) 1814.

Beneficially embodiments of the invention thus provide an electronic component including two POL subassemblies that are stacked and interconnected to form a power module. In some embodiments, the drain of the second POL subassembly is coupled to the source of the first POL subassembly to form a half-bridge power module. The stacking of the two POL subassemblies results in a lower footprint for the power module and, therefore, a higher power density without compromising the power delivered. The power module also has a higher efficiency enabled by lower parasitics. The power module may also include EMI mitigation via an integrated EMI solution, with lower parasitic loop inductance allowing for reduced EMI filtering downstream. Further, the power module has a double side cooled option that can include three cooling layers, as well as a single side cooled option. The power module can be used for various power converters such as, for example, DC-to-DC converters, two-level inverters, full-bridge converters, neutral-point-clamped converter, active neutral-point-clamped converters, T-type converters, modular multilevel converters, and synchronous buck converters. Such power converters may be used in various industries and applications such as, for example, in the fields of transportation (including, but not limited to automotive, locomotive, and aviation) and renewal energy (including, but not limited to, solar energy), and industrial motors. Additionally, the first and second POL subassemblies may have the same or different dimensions and/or footprints, allowing the stacked architecture to be tailored for different electrical, thermal, and packaging requirements. The power module provides for simplified integration for each converter and gate driver boards along with the reduced area requirement leading to compact design and higher power density.

While the invention has been described in detail in connection with only a limited number of embodiments, it should be readily understood that the invention is not limited to such disclosed embodiments. Rather, the invention can be modified to incorporate any number of variations, alterations, substitutions, or equivalent arrangements not heretofore described, but which are commensurate with the spirit and scope of the invention. Additionally, while various embodiments of the invention have been described, it is to be understood that aspects of the invention may include only some of the described embodiments. Accordingly, the invention is not to be seen as limited by the foregoing description, but is only limited by the scope of the appended claims. In the appended claims, the singular forms of "a," "an," and "the" include their corresponding plural references unless the context clearly dictates otherwise.

Further aspects of the disclosure are provided by the subject matter of the following clauses:
An electronic component comprising: a first subassembly that includes a first power overlay (POL) that provides electrical connections to at least one semiconductor device included in the first subassembly; and a second subassembly that includes a second POL that provides electrical connections to at least one semiconductor device included in the second subassembly; wherein the second subassembly is stacked on the first subassembly with electrical connections between the first and second subassemblies that form a power module.

The electronic component of any preceding clause, wherein the first and second POLs each comprise a dielectric layer having vias and metal interconnects formed thereon to provide the respective electrical connections to the respective at least one semiconductor device.

The electronic component of any preceding clause, further comprising: a shim coupled between the first and second POLs that facilitates at least one of the electrical connections between the first and second subassemblies.

The electronic component of any preceding clause, wherein: the first subassembly further includes a first substrate structure to which the at least one semiconductor device included in the first subassembly is attached; and the second subassembly further includes a second substrate structure attached to the second POL.

The electronic component of any preceding clause, wherein the first and second substrate structures each comprise a ceramic-metal substrate with metal layers bonded to both sides thereof.

The electronic component of any preceding clause, further comprising: at least one lead coupled to the first substrate structure to provide an external connector of the power module.

The electronic component of any preceding clause, further comprising: at least one lead coupled to the second substrate structure to provide another external connector of the power module.

The electronic component of any preceding clause, further comprising: a shim coupled between the second POL and the first substrate structure that facilitates at least one electrical connection therebetween.

The electronic component of any preceding clause, wherein the electrical connections between the first and second subassemblies form a half-bridge power module.

The electronic component of any preceding clause, wherein the at least one semiconductor device included in each of the first and second subassemblies comprises a metal-oxide-semiconductor field-effect transistor (MOSFET).

The electronic component of any preceding clause, wherein a source of the MOSFET included in the first subassembly is coupled to a drain of the MOSFET included in the second subassembly.

The electronic component of any preceding clause, wherein the at least one semiconductor device included in each of the first and second subassemblies comprises an anti-parallel switch-diode pair.

The electronic component of any preceding clause, further comprising: a heat spreader located between the first and second subassemblies that is configured to improve a thermal management of the power module.

The electronic component of any preceding clause, further comprising: a lead located between the first and second subassemblies to provide an external connector of the power module.

The electronic component of any preceding clause, further comprising: a capacitor coupled between the first and second subassemblies in a manner that is configured to mitigate electromagnetic interference (EMI).

The electronic component of any preceding clause, wherein at least one of the first or second POLs comprises a two-layer POL.

The electronic component of any preceding clause, further comprising: at least one lead coupled to at least one of the second POL or the first subassembly to provide an external connector of the power module.

The electronic component any preceding clause, further comprising an insulating material to at least partially fill gaps between and around the first and second subassemblies.

A method of manufacturing an electronic component comprising: fabricating a first subassembly that includes a first power overlay (POL) that provides electrical connections to at least one semiconductor device included in the first subassembly; fabricating a second subassembly that includes a second POL that provides electrical connections to at least one semiconductor device included in the second subassembly; and coupling the second subassembly to the first subassembly by stacking the second subassembly on the first subassembly with electrical connections between the first and second subassemblies that form a power module.

The method of any preceding clause, wherein the coupling the second subassembly to the first subassembly comprises: coupling the second subassembly to the first subassembly either during fabrication of the second subassembly or after fabrication of the second subassembly.

The method of any preceding clause, wherein the coupling the second subassembly to the first subassembly comprises: placing a shim between the first and second POLs that facilitates at least one of the electrical connections between the first and second subassemblies.

The method of any preceding clause, wherein the fabricating the first subassembly comprises: coupling the at least one semiconductor device included in the first subassembly to a first substrate structure.

The method of any preceding clause, wherein the coupling the second subassembly to the first subassembly comprises: placing a shim between the second POL and the first substrate structure that facilitates at least one electrical connection therebetween.

The method of any preceding clause, wherein the fabricating the first subassembly further comprises: coupling a first leadframe to the first substrate structure.

The method of any preceding clause, wherein the fabricating the second subassembly comprises: coupling a second substrate structure to the second POL.

The method of any preceding clause, wherein the fabricating the second subassembly further comprises: coupling a second leadframe to the second substrate structure.

The method of any preceding clause, wherein the coupling the second subassembly to the first subassembly comprises: placing a heat spreader between the first and second subassemblies that is configured to improve a thermal management of the power module.

The method of any preceding clause, wherein the coupling the second subassembly to the first subassembly comprises: placing a third leadframe between the first and second subassemblies.

The method of any preceding clause, wherein the coupling the second subassembly to the first subassembly comprises: placing a capacitor between the first and second subassemblies in a manner that is configured to mitigate electromagnetic interference (EMI).

The method of any preceding clause, wherein the fabricating the first subassembly and the fabricating the second subassembly comprises: fabricating at least one of the first or second POLs as a two-layer POL.

The method of any preceding clause, further comprising: molding the first and second subassemblies via a transfer molding or injection molding process.

An electronic component comprising: a first subassembly comprising: a first substrate structure; at least one semiconductor device disposed on the first substrate structure; and a first power overlay (POL) disposed on the at least one semiconductor device; a second subassembly comprising: at least one semiconductor device; a second POL disposed on the at least one semiconductor device; and a second substrate structure disposed on the second POL; wherein the second subassembly is vertically arranged above the first subassembly with electrical connections between the first and second subassemblies that form a power module.

The electronic component of any preceding clause, further comprising: a shim coupled between the first and second POLs that facilitates at least one of the electrical connections between the first and second subassemblies.

The electronic component of any preceding clause, further comprising: a shim coupled between the second POL and the first substrate structure that facilitates at least one electrical connection therebetween.

The electronic component of any preceding clause, further comprising: a heat spreader located between the first and second subassemblies that is configured to improve a thermal management of the power module.

The electronic component of any preceding clause, further comprising: a capacitor coupled between the first and second subassemblies in a manner that is configured to mitigate electromagnetic interference (EMI).

The electronic component of any preceding clause, wherein at least one of the first or second POLs comprises a two-layer POL.

A stacked half-bridge power module comprising: a first power overlay (POL) subassembly comprising: a source; and a drain; a second POL subassembly stacked on the first POL subassembly such that the first and second POL subassemblies form a half-bridge power module, the second POL subassembly comprising: a source; and a drain coupled to the source of the first POL subassembly.

The stacked half-bridge power module of any preceding clause further comprising a snubber comprising at least one capacitor.

The stacked half-bridge power module of any preceding clause further comprising at least one capacitor integrated with the first and second POL subassemblies and configured to mitigate electromagnetic interference (EMI).

The stacked half-bridge power module of any preceding clause further comprising a heat spreader coupled between the first and second POL subassemblies, the heat spreader configured to improve a thermal management of the stacked half-bridge power module.

The stacked half-bridge power module of any preceding clause further comprising at least one heatsink configured to improve a thermal management of the stacked half-bridge power module.

A method of manufacturing a stacked half-bridge power module, the method comprising: fabricating first and second power overlay (POL) subassembly comprising: a source; and a drain; fabricating a second POL subassembly comprising: a source; and a drain; coupling the second POL subassembly to the first POL subassembly either during fabrication of the second POL subassembly or after fabrication of the second POL subassembly to form a half-bridge power module with the drain of the second POL subassembly coupled to the source of the first POL subassembly.

The method of any preceding clause wherein fabricating the first POL subassembly comprises, for each of the first and second POL subassemblies: fabricating a first POL; coupling the POL to a first substrate; and coupling a first leadframe to the first substrate.

The method of any preceding clause wherein fabricating the second POL subassembly comprises: fabricating a second POL; coupling the second POL the first POL; coupling a second substrate to the second POL; and coupling a second leadframe to the second substrate.

The method of any preceding clause further comprising molding the first and second POL subassemblies via a transfer molding or injection molding process.

A stacked back-to-back power module comprising: a first power overlay (POL) subassembly comprising: a drain; and a source; a second POL subassembly stacked on the first POL subassembly such that the first and second POL subassemblies form a stacked back-to-back power module, the second POL subassembly comprising: a drain; and a source; wherein either the drains of the first and second POL subassemblies are coupled to each other or the sources of the first and second POL subassemblies are coupled to each other.

The stacked back-to-back power module of any preceding clause wherein the stacked back-to-back power module is configured to operate as a solid-state circuit breaker.

The stacked back-to-back power module of any preceding clause further comprising at least one metal-oxide varistor (MOV) integrated therein and configured to provide voltage clamping.

The stacked back-to-back power module of any preceding clause further comprising a heat spreader coupled between the first and second POL subassemblies, the heat spreader configured to improve a thermal management of the stacked back-to-back power module.

The stacked back-to-back power module of any preceding clause further comprising at least heatsink configured to improve a thermal management of the stacked back-to-back power module.

A method of manufacturing a stacked back-to-back power module, the method comprising: fabricating first and second power overlay (POL) subassembly comprising: a drain; and a source; fabricating a second POL subassembly comprising: a drain; and a source; coupling the second POL subassembly to the first POL subassembly to form a stacked back-to-back power module with either the drains of the first and second POL subassemblies coupled to each other or the sources of the first and second POL subassemblies coupled to each other.

The method of any preceding clause wherein fabricating the first and second POL subassemblies comprises, for each of the first and second POL subassemblies: fabricating a POL; coupling the POL to a substrate; and coupling a leadframe to the substrate.

The method of any preceding clause further comprising molding the first and second POL subassemblies via a transfer molding or injection molding process.

## Claims

1. An electronic component (200) comprising:
a first subassembly (202) that includes a first power overlay (POL) (204) that provides electrical connections to at least one semiconductor device (212) included in the first subassembly (202); and
a second subassembly (230) that includes a second POL (232) that provides electrical connections to at least one semiconductor device (236) included in the second subassembly (230);
wherein the second subassembly (230) is stacked on the first subassembly (202) with electrical connections between the first and second subassemblies (202)(230) that form a power module.

2. The electronic component (200) of claim 1, wherein the first and second POLs each comprise a dielectric layer (214) (238) having vias (217) (237) and metal interconnects (216)(240) formed thereon to provide the respective electrical connections to the respective at least one semiconductor device (212)(240).

3. The electronic component (200) of any preceding claim, wherein the at least one semiconductor device (212)(240) included in each of the first and second subassemblies (202)(230) comprises a metal-oxide-semiconductor field-effect transistor (MOSFET), and wherein a source of the MOSFET included in the first subassembly (202) is coupled to a drain of the MOSFET included in the second subassembly (230).

4. The electronic component (200) of any preceding claim, further comprising:
a shim (262) coupled between the first and second POLs (204)(232) that facilitates at least one of the electrical connections between the first and second subassemblies (202)(230).

5. The electronic component (200) of any preceding claim, wherein:
the first subassembly (202) further includes a first substrate structure (219) to which the at least one semiconductor device (212) included in the first subassembly (202) is attached; and
the second subassembly (230) further includes a second substrate structure (221) attached to the second POL (232).

6. The electronic component (200) of claim 5, further comprising:
at least one lead (208) coupled to the first substrate structure (219) to provide an external connector of the power module.

7. The electronic component (200) of claim 6, further comprising:
at least one lead (234) coupled to the second substrate structure to provide another external connector of the power module.

8. The electronic component (200) of any preceding claim, wherein the electrical connections between the first and second subassemblies (202)(230) form a half-bridge power module.

9. The electronic component (200) of any preceding claim, further comprising:
a heat spreader (160) located between the first and second subassemblies (202)(230) that is configured to improve a thermal management of the power module.

10. The electronic component (200) of any preceding claim, further comprising:
a lead (208) located between the first and second subassemblies (202)(230) to provide an external connector of the power module.

11. The electronic component (200) of any preceding claim, further comprising:
a capacitor (164) coupled between the first and second subassemblies (202)(230) in a manner that is configured to mitigate electromagnetic interference (EMI).

12. The electronic component (200) of any preceding claim, wherein at least one of the first or second POLs (204)(232) comprises a two-layer POL.

13. The electronic component (200) of any preceding claim, further comprising:
at least one lead (208) coupled to at least one of the second POL (232) or the first subassembly (230) to provide an external connector of the power module.

14. The electronic component (200) of any preceding claim, further comprising:
an insulating material (239) to at least partially fill gaps between and around the first and second subassemblies (202)(230).

15. A method of manufacturing an electronic component (200) comprising:
fabricating a first subassembly (202) that includes a first power overlay (POL) (204) that provides electrical connections to at least one semiconductor device (212) included in the first subassembly (202);
fabricating a second subassembly (230) that includes a second POL (232) that provides electrical connections to at least one semiconductor device (240) included in the second subassembly (230); and
coupling the second subassembly (230) to the first subassembly (202) by stacking the second subassembly (230) on the first subassembly (202) with electrical connections between the first and second subassemblies (202)(230) that form a power module.
